Europäisches Patentamt

European Patent Office

Office européen des brevets

(11) Veröffentlichungsnummer: **0 258 332 B1**

# EUROPÄISCHE PATENTSCHRIFT

(45) Veröffentlichungstag der Patentschrift: **24.06.92**

(21) Anmeldenummer: **87901353.0**

(22) Anmeldetag: **23.02.87**

(86) Internationale Anmeldenummer:
**PCT/DE87/00068**

(87) Internationale Veröffentlichungsnummer:
**WO 87/05170 (27.08.87 87/19)**

(51) Int. Cl.⁵: **H03D 3/00**

54 **VERFAHREN UND VORRICHTUNG ZUR FREQUENZUMSETZUNG FREQUENZMODULIERTER SIGNALE.**

(30) Priorität: **24.02.86 DE 3606250**

(43) Veröffentlichungstag der Anmeldung:
**09.03.88 Patentblatt 88/10**

(45) Bekanntmachung des Hinweises auf die
Patenterteilung:
**24.06.92 Patentblatt 92/26**

(84) Benannte Vertragsstaaten:
**CH DE FR GB LI NL SE**

(56) Entgegenhaltungen:
**DE-A- 3 223 904**
**FR-A- 2 497 039**
**US-A- 3 629 716**

**Patent Abstracts of Japan, vol. 5, No. 192,
(E-85)(864) 8 December 1981 & JP-
A-56114453**

(73) Patentinhaber: **H. u. C. Elektronik GmbH
Gustav-Meyer-Allee 25
W-1000 Berlin 65(DE)**

(72) Erfinder: **HANSEN, Jens
Klopstockstrasse 1-3
W-1000 Berlin 21(DE)**

(74) Vertreter: **Christiansen, Henning, Dipl.-Ing.
Patentanwalt CHRISTIANSEN Pacelliallee
43/45
W-1000 Berlin 33(DE)**

EP 0 258 332 B1

## Beschreibung

Die Erfindung betrifft ein Verfahren und eine Schaltungsanordnung zum Umsetzen frequenzmodulierter Signale über mindestens eine Zwischenfrequenz in Niederfrequenzsignale nach dem Oberbegriff des Hauptanspruchs und des nebengeordneten Anspruchs.

Die DE-OS 30 48 263 beschreibt ein Rundfunkempfangsgerät, das mit einer Mitlauffilteranordnung versehen ist. Das empfangene Signal wird dabei über eine oder mehrere Mischstufen in Zwischenfrequenzsignale umgewandelt, die über Zwischenfrequenzfilter einem Demodulator zugeleitet werden, indem sie in Niederfrequenzsignale umgewandelt werden. Um Störungen so gering wie möglich zu halten, sind die Filter schmalbandig ausgebildet, wobei von der Ausgangsspannung des Demodulators eine Nachsteuerspannung abgeleitet wird, die die Resonanzfrequenz des dem Demodulator vorgeschalteten schmalbandigen Zwischenfrequenzfilters derart verschiebt, daß der jeweilige Momentanwert der Zwischenfrequenz stets innerhalb des Durchlaßbereichs des Filters liegt.

Da die Erzeugung der Nachsteuerspannung zeitlich nach der Mischung und der Selektion erfolgt, treten durch die Rückwärtssteuerung Steuerverzögerungen auf, die im wesentlichen durch die Gruppenlaufzeiten der Filter gegeben sind. Das bedeutet, daß die Steuerspannung für die Filter und die Zwischenfrequenzspannung zeitlich verschoben sind, und es entsteht eine Relativbewegung zwischen dem Filter und der Zwischenfrequenz. Bei hohen Frequenzen führt diese Nachlaufverzögerung zu Schwierigkeiten bei der Nachführung der Filter, wodurch Störungen auftreten können.

Aus der DE-OS 32 23 904 ist ferner eine Filter- und Demodulationsschaltung bekannt, an deren Eingang die Zwischenfrequenz in mindestens zwei parallele Kanäle, die jeweils die Modulationsfrequenzen von unterschiedlichen Frequenzbereichen übertragen, aufgeteilt wird, wobei die Niederfrequenz am Ausgang eines jeden Übertragungskanals das Zwischenfrequenzfilter dieses Kanals und die Oszillatorschaltung der Misch- und Oszillatorschaltung des anderen Kanals nachsteuert.

Bei dieser Schaltungsanordnung muß die Zwischenfrequenz in getrennte Frequenzbänder aufgeteilt werden, so daß die Komponenten des ZF-Kanals zweifach vorhanden sein müssen. Außerdem sind noch zusätzliche Frequenzweichen erforderlich.

Der Erfindung liegt daher die Aufgabe zugrunde, ein vereinfachtes Verfahren der eingangs genannten Gattung und eine entsprechende Schaltungsanordnung zum Umsetzen frequenzmodulierter Signale über mindestens eine Zwischenfrequenz in Niederfrequenzsignale zu schaffen.

Diese Aufgabe wird erfindungsgemäß durch die kennzeichnenden Merkmale des Hauptanspruchs und der nebengeordneten Vorrichtungsansprüche in Verbindung mit den Merkmalen des Oberbegriffs gelöst. Dadurch, daß das demodulierte Signal, das vorher den Oszillator passiert hat, zu diesem selbst zwecks Ansteuerung zurückgeführt wird und daß diese Ansteuerung in der Weise erfolgt, daß im hohen Frequenzbereich der Niederfrequenz eine Hubabsenkung durchgeführt wird, wird die Resonanzfrequenz der Mitlauffilter in den hohen Frequenzen nur wenig hin- und hergeschoben, so daß die Nachführbarkeit der Filter erhöht wird. Diese Hubabsenkung erfolgt vorzugsweise durch eine Phasendrehung der Niederfrequenzsignale, die zur Ansteuerung des Oszillators dienen, wobei diese Phasendrehung in einfacher Weise von einem in den Rückführzweig geschalteten Inverter vorgenommen wird.

Durch die in den Unteransprüchen angegebenen Maßnahmen sind vorteilhafte Weiterbildungen und Verbesserungen möglich.

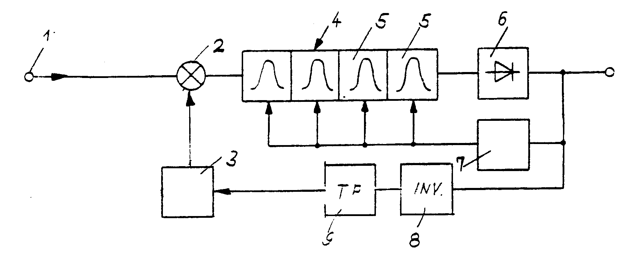

Ein Ausführungsbeispiel der Erfindung ist in der Zeichnung dargestellt und wird in der nachfolgenden Beschreibung näher erläutert. Die einzige Figur zeigt die schaltungsgemäße Ausgestaltung der erfindungsgemäßen Schaltungsanordnung.

In der Figur ist mit 1 die Eingangsklemme der Schaltungsanordnung bezeichnet, an der die frequenzmodulierten Empfangssignale oder die zwischenfrequenten Ausgangssignale einer Zwischenfrequenzstufe liegen. Das Bezugszeichen 2 bezeichnet eine Mischstufe, die mit einem spannungsgesteuerten Oszillator 3 verbunden ist und an eine aus mehreren Mitlauffiltern 5 bestehende Filteranordnung 4 angeschlossen ist. Die Filteranordnung 4 ist mit dem Eingang eines Demodulators 6 verbunden, an dessen Ausgang die niederfrequenten Signale anstehen. Ein erster Rückführungskreis ist über eine Anpassungsschaltung 7 zwischen dem Ausgang des Demodulators 6 und der Filteranordnung 4 und ein zweiter Rückführkreis zwischen Ausgang des Demodulators 6 und Oszillator 3 vorgesehen. In den zweiten Rückführkreis ist ein Inverter 8 und ein Tiefpaß 9 geschaltet.

Die modulierten hochfrequenten Empfangssignale bzw. die Zwischenfrequenzsignale gelangen auf die Mischstufe 2, in der sie mit dem Ausgangssignal des Oszillators 3 zu am Ausgang der Mischstufe anliegenden Zwischenfrequenzsignalen gemischt werden. Die Filteranordnung 4 filtert entsprechend ihrem Durchlaßbereich die Zwischenfrequenzsignale aus, die in dem Demodulator 6 zu Niederfrequenzsignalen demoduliert werden. Die niederfrequente Ausgangsspannung des Demodulators 6 wird der Filteranordnung 4 über die Anpaßschaltung 7 derart zugeführt, daß die Mittenfrequenz der Filter 5 der Momentanfrequenz des der Mischstufe 2 entnehmbaren zwischenfrequenten Signals nachgeführt wird. Wegen der Nachlaufverzögerung sind der Nachführung der Mittenfrequenz bei hohen Frequenzen Grenzen gesetzt. Eine Verbesserung der Nachführbarkeit kann erzielt werden, wenn die Auslenkung, das heißt der Hub des Zwischenfrequenzsignals und somit der Hub des niederfrequenten Signals im höheren Frequenzbereich abgesenkt wird. Eine Hubabsenkung kann dadurch vorgenommen werden, daß der spannungsgesteuerte Oszillator eine Spannung liefert, die zum hohen Frequenzbereich der Niederfrequenz hin immer mehr mit der Zwischenfrequenz mitläuft, das heißt gleichphasig wird. Das bedeutet, daß die auf den Oszillator zurückgeführten Niederfrequenzsignale in der Weise in der Phase gedreht werden müssen, daß bei hohen Frequenzen des Niederfrequenzbereichs ein Mitlaufen der Oszillatorspannung zu der Zwischenfrequenzspannung auftritt.

Da im Mischer eine Spannung der Differenzfrequenz seiner beiden Eingangssignale gebildet wird, verringert sich bei zunehmendem Mitlaufen der Hub des Zwischenfrequenzsignals, wodurch die Mittenfrequenz der Mitlauffilter im hohen Frequenzbereich nur wenig hin- und hergeschoben werden muß. Aufgrund der Laufzeiten der Filter und der damit auftretenden Nachlaufverzögerung tritt für den Fall, daß ein Mitlaufen in dem hohen Frequenzbereich zwischen Oszillatorspannung und Zwischenfrequenzspannung erzielt worden ist, ein Gegenlaufen im niedrigen Frequenzbereich auf, das zu einer Huberhöhung führt. Eine derartige Anhebung des Hubes bei niedrigen Frequenzen des Niederfrequenzbereiches ist aber nicht störend, da die Mittenfrequenz der Mitlauffilter nicht so schnell nachgeführt werden muß.

Die Phasendrehung wird in dem Rückführkreis zwischen Ausgang des Demodulators 6 und Oszillator vorgenommen, wobei, wie aus der Figur ersichtlich, ein Inverter 8 in diesen Kreis geschaltet ist. Der Inverter invertiert das Niederfrequenzsignal, das heißt, er dreht die Phase des Niederfrequenzsignals um 180°. Auf diese Weise wird mit einfachen Mitteln bei Berücksichtigung und direkter Ausnutzung der Laufzeiten die Hubabsenkung im höheren Niederfrequenzbereich realisiert. Zur weiteren Laufzeitverzögerung ist zwischen dem Inverter 8 und dem Oszillator 3 ein Tiefpaß 9 geschaltet, so daß die Laufzeiten der gesamten Schaltungsanordnung in der Weise angepaßt werden können, daß der Übergang vom Gegenlaufen zum Mitlaufen der Oszillatorspannung mit der Zwischenfrequenz im gewünschten Frequenzbereich liegt. Zusätzlich kann, um die Huberhöhung im niedrigen Niederfrequenzbereich etwas abzusenken, ein Hochpaß im Rückführzweig angeordnet sein, dessen Grenzfrequenz (beispielsweise 300 Hz) so gewählt ist, daß er nicht die gewünschte Hubabsenkung im hohen Frequenzbereich beeinflußt.

Mit dem Inverter wird eine Phasendrehung der Niederfrequenzsignale im Rückführungskreis und eine Hubabsenkung der Zwischenfrequenzsignale im höheren Frequenzbereich in einfacher und kostengünstiger Weise erzielt. Eine Phasendrehung kann aber auch auf andere Weise mit Phasendrehgliedern durchgeführt werden.

## Patentansprüche

1. Verfahren zum Umsetzen frequenzmodulierter Signale über mindestens eine Zwischenfrequenz in Niederfrequenzsignale, bei dem die Zwischenfrequenzsignale nach Mischung der frequenzmodulierten Signale mit einer Oszillatorspannung und anschließendem Ausfiltern erzeugt und demoduliert werden, wobei die Resonanzfrequenz der Filter mittels einer vom demodulierten Signal abgeleiteten Steuerspannung entsprechend der Bewegung der Zwischenfrequenz nachgeführt wird und der Oszillator in der Weise angesteuert wird, daß im hohen Frequenzbereich der Niederfrequenz eine Hubabsenkung erfolgt,

   **dadurch gekennzeichnet,**

   daß der Oszillator (3) über einen Oszillatorsteuerkreis durch die auf den Oszillator (3) zurückgeführten, von einem dem Oszillator (3) nachgeschalteten Demodulator (6) aus den demodulierten Zwischenfrequenzsignalen erzeugten, Niederfrequenzsignale angesteuert wird.

2. Verfahren nach Anspruch 1, **dadurch gekennzeichnet,** daß eine Phasendrehung der Niederfrequenzsignale vorgenommen wird.

3. Verfahren nach Anspruch 2, **dadurch gekennzeichnet,** daß die Phasendrehung 180° beträgt.

4. Schaltung zur Durchführung des Verfahrens nach Anspruch 1 mit einer von einem steuerbaren Oszillator angesteuerten Mischstufe, mindestens einem Filter zum Ausfiltern des Zwischenfrequenzsignals und einem dem Filter nachgeschalteten Demodulator, von dessen Ausgangsspannung zum Nachsteuern der Resonanzfrequenz des Filters entsprechend der Bewegung der Zwischenfrequenz abgeleitet ist, **dadurch gekennzeichnet,** daß in den Oszillatorsteuerkreis ein Mittel zur Phasendrehung geschaltet ist.

5. Schaltung zur Durchführung des Verfahrens nach Anspruch 4, **dadurch gekennzeichnet,** daß das Mittel zur Phasendrehung einen Inverter (8) aufweist.

6. Schaltung nach einem der Ansprüche 4 oder 5, **dadurch gekennzeichnet,** daß in den Oszillatorsteuerkreis ein Tiefpaß (9) geschaltet ist.

7. Schaltung nach einem der Ansprüche 4 bis 6, **dadurch gekennzeichnet,** daß in den Oszillatorsteuerkreis ein Hochpaß und/oder ein Bandpaß geschaltet ist, deren Grenzfrequenzen so gewählt sind, daß sie die Hubabsenkung im hohen Frequenzbereich nicht beeinflussen.

## Claims

1. Method for converting, through at least one intermediate frequency, frequency-modulated signals into low frequency signals, in which, after mixing the frequency-modulated signal with an oscillator voltage and subsequent filtering, the low frequency signals are produced and demodulated, the resonance frequency of the filters being tracked, by means of a control voltage derived from the demodulated signal, according to the movement of the intermediate frequency, and the oscillator being driven such that a reduction in deviation occurs in the high frequency range of the low frequency, characterised in that the oscillator (3) is driven, via an oscillator control circuit, by the low frequency signals which are produced from the demodulated intermediate frequency signals and fed back to the oscillator (3) from the demodulator (6) connected to the oscillator (3).

2. Method according to claim 1, characterised in that a phase rotation of the low frequency signals is effected.

3. Method according to claim 2, characterised in that the phase rotation is 180°.

4. Circuit for carrying out the method according to claim 1 having a mixing stage driven by a controllable oscillator, at least one filter for filtering the intermediate frequency signal and a demodulator connected to the filter, the output voltage of which is dissipated to adjust the resonance frequency of the filter according to the movement of the intermediate frequency, characterised in that a means for phase rotation is switched into the oscillator control circuit.

5. Circuit for carrying out the method according to claim 4, characterised in that the means for phase rotation has an inverter (8).

6. Circuit according to either claim 4 or 5, characterised in that a low-pass filter (9) is switched into the oscillator control circuit.

7. Circuit according to any one of claims 4 to 6, characterised in that a high-pass and/or a band-pass filter is switched into the oscillator control circuit, the limit frequencies of which are chosen such that they do not influence the deviation drop in the high frequency range.

## Revendications

1. Procédé pour convertir des signaux modulés en fréquence en signaux à basse fréquence en passant par au moins une fréquence intermédiaire, dans lequel les signaux à fréquence intermédiaire sont produits et démodulés après mélange des signaux modulés en fréquence avec une tension d'oscillateur, puis filtrage, la fréquence de résonance des filtres étant asservie au mouvement de la fréquence intermédiaire au moyen d'une tension de commande tirée du signal démodulé, et l'oscillateur étant commandé de manière qu'il y ait une diminution d'excursion dans le haut du domaine des basses fréquences,
caractérisé
par le fait que l'oscillateur (3) est commandé, via une boucle de commande d'oscillateur, par les signaux à basse fréquence qui sont produits à partir des signaux à fréquence intermédiaire démodulés par un démodulateur (6) monté à la suite de l'oscillateur (3), lesdits signaux à basse fréquence étant renvoyés à l'oscillateur (3).

2. Procédé selon revendication 1, caractérisé par le fait que l'on effectue une rotation de phase des signaux à basse fréquence.

3. Procédé selon revendication 2, caractérisé par le fait que la rotation de phase vaut 180°.

4. Dispositif de mise en oeuvre du procédé selon revendication 1, comportant un étage mélangeur piloté par un oscillateur commandé, au moins un filtre pour filtrer le signal à fréquence intermédiaire, et un démodulateur en aval du filtre, la tension de sortie de ce démodulateur étant prélevée pour la commande de retouche de la fréquence de résonance du filtre en fonction du mouvement de la fréquence intermédiaire, caractérisé par le fait qu'un moyen de rotation de phase est monté dans la boucle de commande de l'oscillateur.

5. Dispositif de mise en oeuvre du procédé selon revendication 4, caractérisé par le fait que le moyen de rotation de phase présente un inverseur (8).

6. Dispositif selon l'une des revendications 4 ou 5, caractérisé par le fait qu'un filtre passe-bas (9) est monté dans la boucle de commande d'oscillateur.

7. Dispositif selon l'une des revendications 4 à 6, caractérisé par le fait qu'il y a, dans la boucle de commande d'oscillateur, un filtre passe-haut et/ou un filtre passebande, dont la ou les fréquences-limites sont choisies de manière à ne pas influencer la diminution d'excursion dans le haut de la plage de fréquence.